# EUROPÄISCHE PATENTSCHRIFT

(11) **EP 0 838 985 B1**
(45) Veröffentlichungstag und Bekanntmachung des Hinweises auf die Patenterteilung: **05.02.2003**
(21) Anmeldenummer: 97117195.4
(22) Anmeldetag: 04.10.1997
(51) Int. Cl.: H05K 7/14, H05K 9/00

(54) **Kontaktelement zur elektrischen Kontaktierung von Leiterkarten mit einer vorderen Modulschiene eines Baugruppenträgers**
Device for connecting circuit boards to front rail of a electronic rack
Dispositif pour le contact électrique de cartes de circuit au rail avant d'une baie électronique

(30) Priorität: 25.10.1996 DE 19644416
(43) Veröffentlichungstag der Anmeldung: 29.04.1998
(73) Patentinhaber: Schroff GmbH, D-75334 Straubenhardt (DE)
(72) Erfinder: Günther, Hans-Ulrich, 76327 Pfinztal (DE); Mazura, Paul, 76302 Karlsbad (DE); Haag, Volker, 75323 Bad Wildbad (DE); Pfeifer, Klaus, 76199 Karlsruhe (DE); Thalau, Klaus-Michael, 76316 Malsch (DE); Joist, Michael, 76571 Gaggenau (DE); Weiss, Udo, 75334 Staubenhardt (DE)
(74) Vertreter: Durm, Klaus, Dr.-Ing.

(56) Entgegenhaltungen:
- EP-A- 0 025 953
- DE-A- 3 624 883
- DE-U- 8 906 491
- DE-U- 29 509 185

## Beschreibung

Die Erfindung betrifft ein Kontaktelement zur elektrischen Kontaktierung von Leiterkarten mit einer vorderen Modulschiene eines Baugruppenträgers oder eines baugruppenträgerähnlichen Gehäuses. Ein solches Kontaktelement ist am vorderen Bereich einer Führungsschiene befestigt, welche eine Führungsnut zum Einschieben einer der Leiterkarten aufweist und in wenigstens ein Positionierloch der Modulschiene einsteckbar ist. Es besteht aus wenigstens einer Blattfeder, die elastisch an der eingeschobenen Leiterkarte anliegt, einem Kontaktkörper, der einen elektrischen Kontakt mit der Modulschiene herstellt, und einem Verbindungsstück zwischen der Blattfeder und dem Kontaktkörper.

Führungsschienen zum Einschieben von Leiterkarten mit elektrischen oder elektronischen Bauelementen in Baugruppenträger oder baugruppenträgerähnliche Gehäuse sind üblicherweise aus Kunststoff gefertigt. Solange eine Leiterkarte nicht im rückwärtigen Steckverbinder des Baugruppenträgers steckt, können störende Potentialunterschiede zwischen der Leiterkarte und dem Baugruppenträger, welche beispielsweise durch elektrostatische Aufladungen der Leiterkarte entstanden sind, wegen des nichtleitenden Kunststoffs der Führungsschiene nicht ausgeglichen werden. Die Leiterkarte erhält elektrischen Kontakt mit dem Steckverbinder des Baugruppenträgers jedoch erst, wenn sie fast vollständig eingeschoben ist. Darüber hinaus ist ein unkontrollierter Potentialausgleich am Steckverbinder unerwünscht, da hierbei möglicherweise empfindliche elektronische Bauelemente geschädigt werden.

Um die genannten Probleme beim Einschieben von Leiterkarten in Führungsschienen von Baugruppenträgern zu umgehen, werden am vorderen Bereich der Führungsschienen Kontaktelemente befestigt, welche einen elektrischen Kontakt zwischen der eingeschobenen Leiterkarte und einer vorderen Modulschiene herstellen. Solche Kontaktelemente bestehen üblicherweise aus einer Blattfeder und einem Kontaktkörper, die über ein Verbindungsstück verbunden sind. Die Blattfeder liegt beim Einschieben der Leiterkarte an gedruckten Potentialausgleichsleiterbahnen der Leiterkarte federnd an, während der Kontaktkörper auf der Modulschiene aufliegt. In vielen Fällen wird so ein voreilender Potentialausgleich zwischen einer Leiterkarte und einer vorderen Modulschiene, und somit dem Baugruppenträger, bereits hergestellt, wenn die Leiterkarte eingeschoben wird. Beim Kontaktieren des Steckverbinders besteht dann kein Potentialunterschied zwischen der Leiterkarte und dem Baugruppenträger mehr.

Ein Kontaktelement der eingangs genannten Art ist aus der DE 296 02 428 U1 bekannt. Das dort beschriebene Kontaktelement ist in einen Klemmbereich und einen Haltebereich unterteilt, wobei der Klemmbereich zwei Blattfedern umfaßt, zwischen denen eine Leiterkarte eingeschoben wird, und der Haltebereich auf die vordere untere Modulschiene eines Baugruppenträgers aufgeschnappt wird.

Auch aus der EP 0 399 091 B1 ist ein Kontaktelement der eingangs genannten Art bekannt. Das hier beschriebene Kontaktelement besitzt zwei Blattfedern, die als U-förmiges Bügelteil in der Führungsnut einer Führungsschiene sitzen, sowie einen Kontaktkörper, der mittels eines über den Seitenschenkel der Führungsschiene übergreifenden Verbindungsteils mit den Blattfedern verbunden ist und durch eine angeformte Kontaktspitze, die auf die Oberfläche der Modulschiene aufgedrückt wird, elektrischen Kontakt mit der Modulschiene erhält.

Den Kontaktelementen nach dem Stand der Technik ist gemeinsam, daß die Kontaktierung mit der Modulschiene zumindest dann unbefriedigend ist, wenn die Modulschiene aus Aluminium besteht und eloxierte Oberflächen aufweist. Da eloxierte Aluminiumoberflächen beständig und unempfindlich sind, werden Profilschienen, die in aller Regel aus Aluminium bestehen, jedoch bevorzugt mit eloxierten Oberflächen verwendet.

Der Erfindung liegt daher die Aufgabe zugrunde, ein Kontaktelement der eingangs genannten Art zu verbessern, so daß ein sicherer voreilender Potentialausgleich zwischen einer Leiterkarte und einer vorderen Modulschiene eines Baugruppenträgers beim Einschieben der Leiterkarte auch dann gewährleistet ist, wenn die Modulschiene mit einer eloxierten Oberfläche versehen ist.

Diese Aufgabe ist durch ein Kontaktelement mit den Merkmalen des Anspruchs 1 gelöst.

Vorteilhafte Ausgestaltungen und Weiterbildungen der Erfindung ergeben sich aus den Ansprüchen 2 bis 7.

Erfindungsgemäß ist also der Kontaktkörper des Kontaktelements im wesentlichen U-förmig ausgebildet und kann zusammen mit der Führungsschiene in eines der Positionierlöcher der Modulschiene klemmend eingesteckt werden. Die beiden U-Schenkel des Kontaktkörpers verjüngen sich zu ihren Enden hin und sind gegeneinander elastisch verformbar. Diese Ausgestaltung des Kontaktkörpers ermöglicht also, daß die Außenkanten der U-Schenkel zunächst ohne Schwierigkeiten in das entsprechende Positionierloch der Modulschiene eingeführt werden können. Beim weiteren Einschieben des Kontaktkörpers berühren die Außenkanten der U-Schenkel die Innenkanten des Positionierlochs, wobei sich der Anpreßdruck beim weiteren Einschieben erhöht. Die federnd verformbaren U-Schenkel gewährleisten dabei, daß der Kontaktkörper nicht auf halbem Wege steckenbleibt.

Die Bewegung der Außenkanten der beiden U-Schenkel an den Innenkanten der Positionierlöcher bei gleichzeitig einwirkender Anpreßkraft bewirkt, daß in jedem Fall ein hervorragender elektrischer Kontakt zwischen dem Kontaktkörper und der Modulschiene entsteht, auch wenn die Modulschiene eine eloxierte Oberfläche aufweist.

Darüber hinaus ist es üblich, daß die Positionierlöcher erst nach dem Eloxieren der Modulschienen ausgestanzt werden, so daß deren Innenkanten keine Eloxalschicht aufweisen. Es ist daher besonders vorteilhaft, wenn der Kontaktkörper der Kontaktelemente an den Innenkanten der Positionierlöcher anliegt.

Vorzugsweise besitzen die Außenseiten der U-Schenkel des Kontaktkörpers je einen scharfkantigen Rand, der in die Oberfläche der Innenkanten der Positionierlöcher eindringt. Dieser scharfkantige Rand kann zum Beispiel ein Stanzgrat sein, der ohnehin entsteht, wenn das Kontaktelement durch Ausstanzen gefertigt wird.

Die Stabilität des Kontaktkörpers wird erhöht, wenn die U-Schenkel an ihren Auβenseiten abgebogen sind. Dadurch können höhere Andruckkräfte zwischen den Außenkanten der U-Schenkel und den Innenkanten der Positionierlöcher erzielt werden.

Die Führungsschienen, an denen die erfindungsgemäßen Kontaktelemente befestigt werden, weisen üblicherweise Schnapphaken auf, welche in die Positionierlöcher der Modulschiene eingesteckt werden und die Führungsschienen in ihrer Position halten. Es ist daher besonders vorteilhaft, wenn der Kontaktkörper des Kontaktelements der Form eines solchen Schnapphakens nachgebildet ist und mit diesem zusammen in eines der Positionierlöcher der Modulschiene einsteckbar ist. Dabei können die U-Schenkel des Kontaktkörpers die Seitenkanten des Schnapphakens überdecken und diesen somit flankieren. So wird die Funktion des Schnapphakens durch den Kontaktkörper des Kontaktelements nicht beeinträchtigt.

Das Kontaktelement nach der Erfindung kann mit zwei Blattfedern versehen sein, die zusammen mit einem diese verbindenden Bodenteil einen U-förmigen Federkörper bilden. Dieser Federkörper sitzt zweckmäßigerweise in Aussparungen der Führungsnut in der Führungsschiene und umgreift somit die Leiterkarte beim Einschieben an deren unteren Rand, wobei die beiden Blattfedern entlang der Leiterkarte schleifen, während diese in die Führungsschiene eingeschoben wird.

Fertigungstechnisch besonders vorteilhaft ist es, wenn das erfindungsgemäße Kontaktelement aus einem gestanzten und anschließend mehrfach abgebogenen Metallblech gefertigt ist.

Ein Ausführungsbeispiel der Erfindung wird im folgenden anhand der Zeichnungen näher beschrieben. Es zeigen:
- Figur 1: eine perspektivische Ansicht eines Kontaktelements;
- Figur 2: eine Seitenansicht eines Kontaktelements;
- Figur 3: eine Draufsicht auf ein Kontaktelement;
- Figur 4: eine Führungsschiene, die in eine Modulschiene eingesteckt und mit einem Kontaktelement versehen ist, in einer perspektivischen Ansicht von oben;
- Figur 5: eine Darstellung wie Figur 4, jedoch in einer perspektivischen Ansicht von unten;
- Figur 6: eine Teilschnittdarstellung entsprechend Figur 5;
- Figur 7: eine Darstellung wie Figur 4, jedoch in einer Seitenansicht.

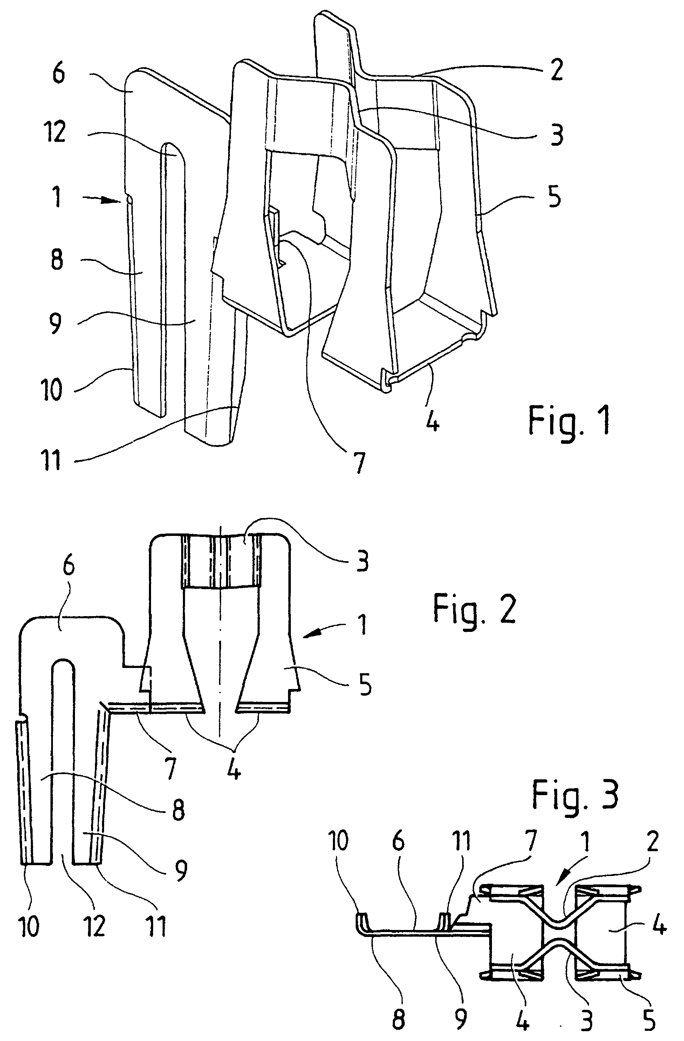

Das in Figur 1 dargestellte Kontaktelement 1 besteht aus einer linken Blattfeder 2 und einer rechten Blattfeder 3, welche über ein Bodenteil 4 verbunden sind und mit diesem einen U-förmigen Federkörper 5 bilden, sowie einem Kontaktkörper 6, der mit dem Federkörper 5 über ein Verbindungsstück 7 zusammenhängt. Der Kontaktkörper 6 ist U-förmig ausgebildet und weist einen vorderen U-Schenkel 8 sowie einen hinteren U-Schenkel 9 auf. Die beiden U-Schenkel 8, 9 sind an ihren Außenkanten 10, 11 rechtwinklig abgebogen. Eine Schlitzung 12 des Kontaktkörpers 6 ist so dimensioniert, daß der vordere U-Schenkel 8 und der hintere U-Schenkel 9 federnd zusammengedrückt werden können.

In Figur 2, einer Seitenansicht des Kontaktelements 1, ist zu erkennen, daß das Bodenteil 4 des Federkörpers 5 aus Gründen der Einpassung in eine (hier nicht dargestellte) Führungsschiene zweigeteilt ist.

Figur 2 verdeutlicht auch, daß sich die beiden U-Schenkel 8, 9 des Kontaktkörpers 6 nach unten verjüngen, und zwar so, daß die Außenkanten 10, 11 um jeweils etwa 2,5 Winkelgrade von der Vertikalen abweichen.

Figur 3, eine Draufsicht auf das Kontaktelement 1, verdeutlicht, daß die linke Blattfeder 2 und die rechte Blattfeder 3 zwischenliegend einen Spalt bilden, durch den eine (nicht dargestellte) Leiterkarte eingeschoben und dadurch elektrisch kontaktiert wird. Die Abbiegungen der beiden Außenkanten 10, 11 der U-Schenkel 8, 9 des Kontaktkörpers 6 gehen aus Figur 3 ebenfalls deutlich hervor.

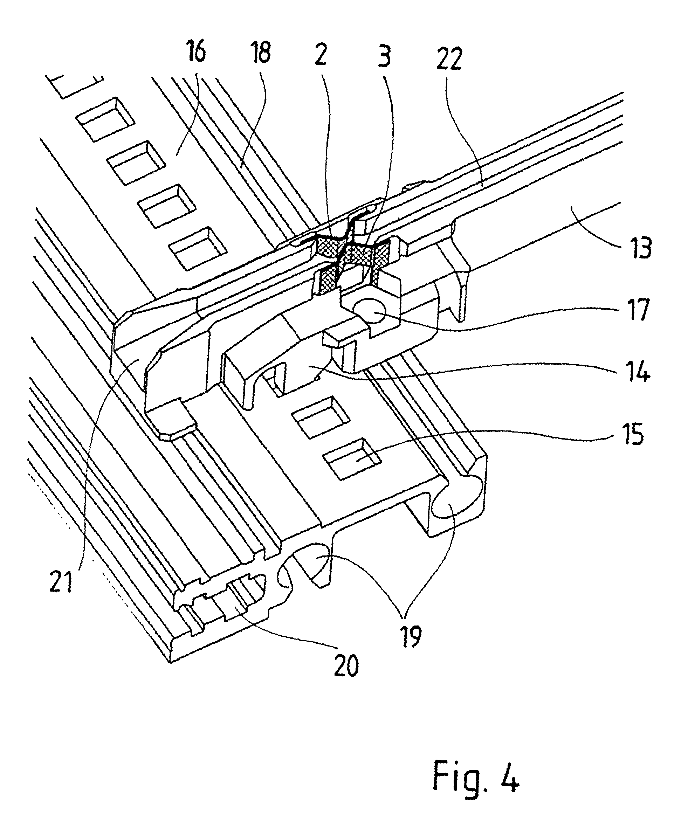

Figur 4 ist eine perspektivische Darstellung einer Führungsschiene 13, die mit einem Schnapphaken 14 in ein Positionierloch 15 einer Modulschiene 16 eingesteckt ist. Die Führungsschiene 13 wird mittels einer Bohrung 17 und einer Befestigungsnut 18 mit der Modulschiene 16 verschraubt. Zur Befestigung der Modulschiene 16 an einer Seitenwand dienen zwei Gewindelöcher 19. An der Vorderseite der Modulschiene 16 befindet sich eine nach vorne offene Nut 20, in die ein (nicht dargestellter) Gewindestreifen zur Befestigung einer (ebenfalls nicht dargestellten) Frontplatte eingeschoben werden kann.

Eine Leiterkarte wird nun in eine Einführschräge 21 gesetzt und entlang einer Führungsnut 22 der Führungsschiene 13 eingeschoben. Hierbei wird sie zwischen der linken Blattfeder 2 und der rechten Blattfeder 3 des in die Führungsschiene 13 eingesetzten Kontaktelements 1 hindurchgeführt, wobei sich die Blattfedern 2, 3 federnd an die Leiterkarte anlegen und diese elektrisch kontaktieren.

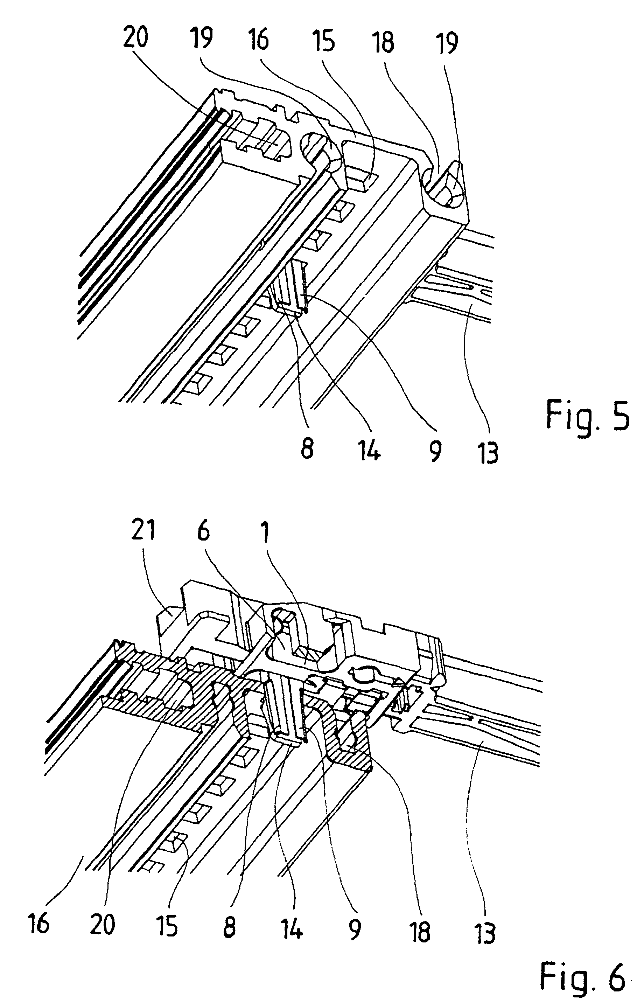

Figur 5 zeigt die Anordnung aus Figur 4 aus einer anderen Perspektive. Es ist dabei deutlich zu sehen, wie der Schnapphaken 14 der Führungsschiene 13 in einem Positionierloch 15 der Modulschiene 16 sitzt. Die beiden U-Schenkel 8, 9 des Kontaktkörpers 6 des Kontaktelements 1 sind zusammen mit dem Schnapphaken 14 in das Positionierloch 15 eingesteckt, wobei die Außenkanten 10, 11 der beiden U-Schenkel 8, 9 klemmend in den Innenkanten des Positionierlochs 15 sitzen und hierdurch den elektrischen Kontakt mit der Modulschiene 16 herstellen. Die beiden U-Schenkel 8, 9 sind so geformt, daß sie den Schnapphaken 14 seitlich flankieren und somit dessen Funktion nicht beeinträchtigen.

Figur 6 zeigt eine Schnittdarstellung der Anordnung aus Figur 5, aus derselben Blickrichtung. Hierdurch ist die parallele Anordnung des Schnapphakens 14 und der beiden U-Schenkel 8, 9 des Kontaktelements 1 noch deutlicher erkennbar.

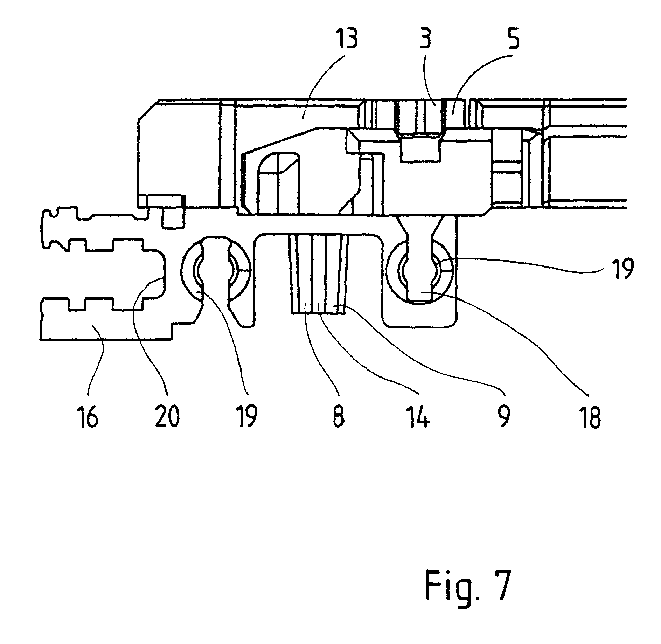

Figur 7 zeigt eine Seitenansicht der Anordnung, die auch in den Figuren 4 bis 6 dargestellt ist. Auf die Modulschiene 16 ist die Führungsschiene 13 mittels ihres Schnapphakens 14 aufgesetzt. An der Oberkante der Führungsschiene 13 ist die rechte Blattfeder 3 des Federkörpers 5 zu erkennen, der einstückig mit den am Schnapphaken 14 sichtbaren U-Schenkeln 8, 9 des Kontaktkörpers 6 verbunden ist. Auf diese Weise ist eine elektrische Kontaktierung zwischen der (nicht dargestellten) Leiterkarte und der Modulschiene 16 gewährleistet.

### Zusammenstellung der Bezugszeichen

- 1: Kontaktelement
- 2: Blattfeder (linke)
- 3: Blattfeder (rechte)
- 4: Bodenteil
- 5: Federkörper
- 6: Kontaktkörper
- 7: Verbindungsstück
- 8: U-Schenkel (vorderer)
- 9: U-Schenkel (hinterer)
- 10: Außenkante (von 8)
- 11: Außenkante (von 9)
- 12: Schlitzung (von 6)
- 13: Führungsschiene
- 14: Schnapphaken
- 15: Positionierloch
- 16: Modulschiene
- 17: Bohrung
- 18: Befestigungsnut
- 19: Gewindeloch
- 20: Nut
- 21: Einführschräge
- 22: Führungsnut

## Patentansprüche

1. Kontaktelement zur elektrischen Kontaktierung von Leiterkarten mit einer vorderen Modulschiene eines Baugruppenträgers oder eines baugruppenträgerähnlichen Gehäuses, wobei das Kontaktelement am vorderen Bereich einer Führungsschiene befestigt ist, welche eine Führungsnut zum Einschieben einer der Leiterkarten aufweist und in wenigstens ein Positionierloch der Modulschiene einsteckbar ist, bestehend aus
- wenigstens einer Blattfeder (2, 3), die elastisch an der eingeschobenen Leiterkarte anliegt,
- einem Kontaktkörper (6), der einen elektrischen Kontakt mit der Modulschiene herstellt,
- und einem Verbindungsstück (7) zwischen der Blattfeder und dem Kontaktkörper,
**dadurch gekennzeichnet,**
- **daß** der Kontaktkörper (6) des Kontaktelements (1) im wesentlichen U-förmig ausgebildet ist,
- wobei sich die beiden U-Schenkel (8, 9) zu ihren Enden hin verjüngen,
- während sie gegeneinander elastisch verformbar sind,
- und **daß** der Kontaktkörper (6) zusammen mit der Führungsschiene (13) in eines der Positionierlöcher (15) der Modulschiene (16) klemmend einsteckbar ist.

2. Kontaktelement nach Anspruch 1, **dadurch gekennzeichnet, daß** die Außenkanten (10, 11) der U-Schenkel (8, 9) des Kontaktkörpers (6) je einen scharfkantigen Rand aufweisen.

3. Kontaktelement nach einem der Ansprüche 1 oder 2, **dadurch gekennzeichnet, daß** die U-Schenkel (8, 9) an ihren Außenkanten (10, 11) abgebogen sind.

4. Kontaktelement nach einem der Ansprüche 1 bis 3, **dadurch gekennzeichnet, daß** der Kontaktkörper (6) der Form eines Schnapphakens (14) der Führungsschiene (13) nachgebildet ist und mit diesem zusammen in eines der Positionierlöcher (15) der Modulschiene (16) einsteckbar ist.

5. Kontaktelement nach den Ansprüchen 3 und 4, **dadurch gekennzeichnet, daß** die U-Schenkel (8, 9) des Kontaktkörpers (6) die Seitenkanten des Schnapphakens (14) überdecken.

6. Kontaktelement nach einem der Ansprüche 1 bis 5, **dadurch gekennzeichnet, daß** zwei Blattfedern (2, 3) vorgesehen sind, die zusammen mit einem diese verbindenden Bodenteil (4) einen U-förmigen Federkörper (5) bilden, welcher in Aussparungen der Führungsnut (22) in der Führungsschiene (13) sitzt und die Leiterkarte an deren unteren Rand umgreift.

7. Kontaktelement nach einem der Ansprüche 1 bis 6, **dadurch gekennzeichnet, daß** es aus einem gestanzten und anschließend abgebogenen Metallblech gefertigt ist.

## Claims

1. Contact element for electrically contacting circuit cards with a front module rail of a rack or a rack-like housing, wherein the contact element is secured at the front region of a guide rail which has a guide groove for insertion of a circuit card and is insertable into at least one positioning hole of a module rail, consisting of:
- at least one leaf spring (2, 3) which elastically bear against the inserted circuit card;
- a contact body (6) which makes electric contact with the module rail; and
- a connection member (7) between the leaf spring and the contact body.
**characterised in that**:
- the contact body (6) of the contact element (1) is formed essentially in a U-shape;
- wherein the two U-limbs (8, 9) taper towards their ends;
- while bearing elastically deformable relative to each other; and
- that the contact body (6) together with the guide rail (13) are clampingly insertable into one of the positioning holes (15) of the module rail (16).

2. A contact element according to Claim 1, **characterised in that** the outer edges (10, 11) of the U-limbs (8, 9) of the contact body (6) have a sharp-edged rim respectively.

3. A contact element according to one of Claims 1 or 2, **characterised in that** the U-limbs (8, 9) are bent at their outer edges (10, 11).

4. A contact element according to one of Claims 1 - 3, **characterised in that** the contact body (6) is constructed according to the shape of a snap-in hook (14) of the guide rail (13) and together with it is insertable in one of the positioning holes (15) of the module rail (16).

5. A contact element according to Claims 3 and 4, **characterised in that** the U-limbs (8, 9) of the contact body (6) overlap the side edges of the snap-in hook (14).

6. A contact element according to one of Claims 1 - 5, **characterised in that** two leaf springs (2, 3) are provided that form a U-shaped spring body (5) together with a bottom part (4) connecting them, which body is seated in recesses of the guide groove (22) in the guide rail (13) and surrounds the circuit card at its lower edge.

7. A contact element according to one of Claims 1 - 6, **characterised in that** it is made from a stamped-out and subsequently bent metallic sheet.

## Revendications

1. Elément de contact pour la mise en contact électrique de cartes imprimées avec un rail modulaire avant d'une baie pour modules électroniques ou d'un boîtier analogue à une baie, l'élément de contact étant fixé sur la zone avant d'un rail de guidage, qui présente une rainure de guidage pour l'insertion de l'une des cartes imprimées et peut être emmanché dans au moins un trou de positionnement du rail modulaire, comprenant
- au moins un ressort à lames (2, 3), qui s'applique élastiquement sur la carte imprimée enfichée,
- un corps de contact (6), qui établit un contact électrique avec le rail modulaire,
- et une pièce de jonction (7) entre le ressort à lames et le corps de contact,
**caractérisé**
- **en ce que** le corps de contact (6) de l'élément de contact (1) a une réalisation essentiellement en U,
- les deux branches du U (8, 9) se rétrécissent en direction de leurs extrémités,
- tandis qu'elles sont déformables élastiquement l'une par rapport à l'autre,
- et **en ce que** le corps de contact (6) peut être emmanché avec un effet de coinçage avec le rail de guidage (13) dans l'un des trous de positionnement (15) du rail modulaire (16).

2. Elément de contact suivant la revendication 1, **caractérisé en ce que** chaque bord extérieur (10, 11) des branches du U (8, 9) du corps de contact (6) présente un rebord à angles vifs.

3. Elément de contact suivant l'une des revendications 1 et 2, **caractérisé en ce que** les branches du U (8, 9) sont pliées sur leurs bords extérieurs (10, 11).

4. Elément de contact suivant l'une des revendications 1 à 3, **caractérisé en ce que** le corps de contact (6) est la reproduction de la forme d'un crochet d'encliquetage (14) du rail de guidage (13), avec lequel il peut être emmanché dans l'un des trous de positionnement (15) du rail modulaire (16).

5. Elément de contact suivant les revendications 3 et 4, **caractérisé en ce que** les branches du U (8, 9) du corps de contact (6) recouvrent les bords latéraux du crochet d'encliquetage (14).

6. Elément de contact suivant l'une des revendications 1 à 5, **caractérisé en qu'**il est prévu deux ressorts à lames (2, 3), qui forment avec une partie de base (4) les assemblant un corps élastique en U (5), qui repose dans des évidements de la rainure de guidage (22) du rail de guidage (13) et enserre la carte imprimée sur son bord inférieur.

7. Elément de contact suivant l'une des revendications 1 à 6, **caractérisé en ce qu'**il est fabriqué en une tôle métallique découpée puis pliée.
